**Europäisches Patentamt**

**European Patent Office**

**Office européen des brevets**

(19)

(11) Numéro de publication: **0 038 725**
**B1**

(12) # FASCICULE DE BREVET EUROPEEN

(45) Date de publication du fascicule du brevet:
01.02.84

(51) Int. Cl.³: **H 01 L 27/14, H 04 N 3/15**

(21) Numéro de dépôt: **81400194.7**

(22) Date de dépôt: **06.02.81**

(54) Dispositif photosensible lu par transfert de charges, et caméra de télévision comportant un tel dispositif.

(30) Priorité: **23.04.80 FR 8009112**

(43) Date de publication de la demande:
**28.10.81 Bulletin 81/43**

(45) Mention de la délivrance du brevet:
**01.02.84 Bulletin 84/5**

(84) Etats contractants désignés:
**DE FR GB**

(56) Documents cités:
**DE - A - 2 606 108**
**FR - A - 2 314 584**
**FR - A - 2 367 353**
**FR - A - 2 376 517**
**US - A - 4 016 550**
**US - A - 4 087 833**

**IEEE JOURNAL OF SOLID STATE CIRCUITS, vol. SC-14, no. 3, juin 1979 New York, US, R. KOCH: "Charge injections device with CCD readout", pages 604-608**

(73) Titulaire: **THOMSON-CSF, 173, Boulevard Haussmann, F-75379 Paris Cedex 08 (FR)**

(72) Inventeur: **Berger, Jean-Luc, THOMSON-CSF SCPI 173, bld Haussmann, F-75360 Paris Cedex 08 (FR)**

(74) Mandataire: **Mayeux, Michèle et al, THOMSON-CSF SCPI 173, Bld Haussmann, F-75379 Paris Cedex 08 (FR)**

BUNDESDRUCKEREI BERLIN

Dispositif photosensible lu par transfert de charges, et camera de télévision comportant un tel dispositif

La présente invention concerne un dispositif photosensible lu par transfert de charges. Elle concerne également une caméra de télévision comportant un tel dispositif.

On connaît dans l'art antérieur, notamment par l'ouvrage de C. H. SEQUIN et M. F. TOMPSETT intitulé »Charge transfer devices«, pages 152 à 169, essentiellement deux types de dispositifs photosensibles utilisant le transfert de charges. Ce sont:

— d'une part, les dispositifs photosensibles à transfert de charges dans lesquels le rayonnement lumineux est envoyé sur des registres à transfert de charges. On connaît diverses organisations possibles des registres soumis au rayonnement et des registres à transfert de charges qui servent au stockage des charges avant leur lecture; les organisations les plus courantes sont du type »à transfert de trame« ou »à structure interligne«. Ces dispositifs présentent l'inconvénient de nécessiter de grandes surfaces de dispositifs à transfert de charges alors qu'il est actuellement difficile d'obtenir des rendements élevés pour la fabrication de ces grandes surfaces;

— d'autre part, les dispositifs photosensibles du type C. I. D. (Charge Injection Devices) qui ne présentent pas cet inconvénient. Ces dispositifs comportent une matrice de points photosensibles constitués de deux capacité MOS couplées par une grille. L'une des capacités est soumise au rayonnement lumineux. Les charges induites sous cette capacité sont périodiquement transférées dans la capacité voisine et la lecture des charges est effectuée par un transistor MOS. Deux registres à décalages numériques permettent l'adressage de chaque point en vue de sa lecture: — les capacités d'une même ligne qui sont soumises au rayonnement sont reliées en parallèle et adressées par l'un des registre tandis que les capacités d'une même colonne qui servent à la lecture sont reliées en parallèle et adressés par l'autre registre. Les dispositifs C. I. D. présentent l'inconvénient de nécessiter une ré-injection des charges dans le substrat semi-conducteur où les capacités sont intégrées, pendant ou après la lecture des charges. Cette réinjection nécessite pour être efficace l'emploi de substrats épitaxiés ou de diffusions collectrices. Elle est par ailleurs difficile à contrôler et peut être l'occasion d'une rémanence, dans le cas où elle est incomplète. De plus, dans les dispositifs du type C. I. D., la lecture des charges se fait sur une forte capacité ce qui réduit le rapport signal/bruit et cette capacité dépend du nombre de lignes.

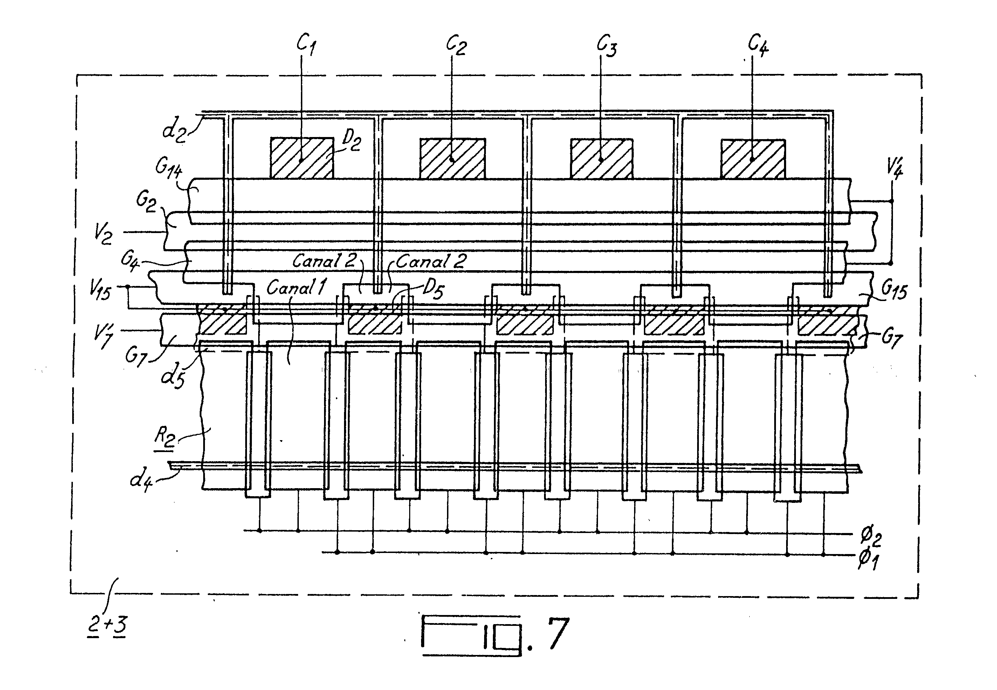

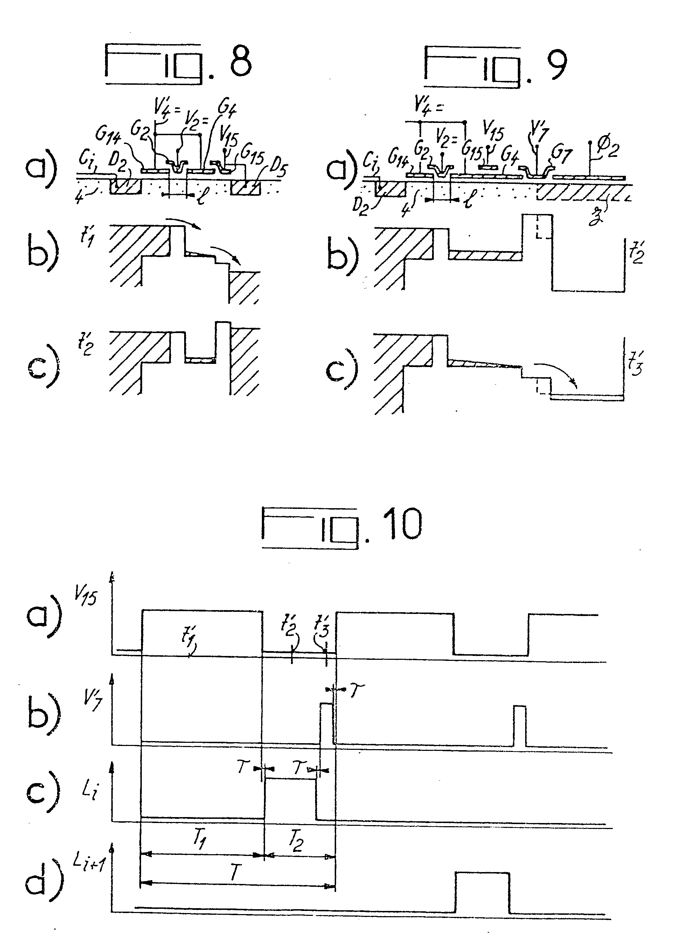

On connaît par ailleurs par l'article paru dans la revue »I.E.E.E. Journal of solid-state circuits«, volume SC 14, numéro 3, juin 1979, pages 604 à 608, un dispositif photosensible qui comporte une matrice du type C.I.D. lue par transfert de charge (voir en particulier les figures 7 et 8 de cet article et leur commentaire). Dans ce dispositif, l'adressage des capacités de lecture est effectuée par un registre à décalages C.C.D. (Charge Coupled Devices).

La lecture de chaque ligne de la matrice se fait en deux étapes:

— dans une première étape, on fixe le potentiel de toutes les capacités de lecture. Il y a transfert de charges transversalement dans le registre C.C.D. et évacuation de ces charges par des transistors MOS $TG_2$;
— dans une deuxième étape, la transfert de charges sous les capacités de lecture provoque l'injection dans le registre C.C.D. de charges-signal qui sont lues en série par transfert longitudinal.

Le transfert des charges est du type »Bucket Brigade«, c'est-à-dire qu'il se fait par l'intermédiaire de l'analogue d'un transistor MOS polarisé en saturation.

Un inconvénient de ce dispositif est que pour être efficace, ce type de transfert demande un temps relativement long. Or pour que ce dispositif soit exploitable par une caméra de télévision, la première étape et la deuxième jusqu'à l'injection des charges signal dans le registre C.C.D. doivent avoir lieu pendant le temps de retour ligne, qui n'est que de 12 $\mu$s dans le standard 625 lignes. Pendant le temps de lecture ligne, les charges injectées dans le registre C.C.D. sont lues en série et il y a ré-injection des charges dans le substrat semi-conducteur.

Par contre un avantage de ce dispositif par rapport aux dispositifs C.I.D. classiques est que la lecture des charges ne se fait plus sur une forte capacité et ne dépend plus nombre de lignes.

La présente invention concerne un dispositif photosensible lu par transfert de charges qui présente de grands avantages par rapport aux dispositifs connus.

Le dispositif selon la présente invention comporte:

— n lignes de m points photosensibles, chaque point photosensible étant constitué par l'intégration sur un substrat semiconducteur d'une capacité MOS $C_0$, comportant une grille $G_0$ commune aux points d'une même ligne, et d'une diode de lecture $D_1$, séparée de la grille $G_0$ par une grille écran $G_1$ portée à un potential constant $(V_1)$, m connexions métalliques $(C_1 \ldots C_m)$ reliant en parallèle n diodes appartenant à des lignes différentes;
— m diodes $D_2$, intégrées sur le même substrat semi-conducteur, auxquelles aboutissent les m connexions métalliques, ces diodes étant suivie par une grille $G_2$ portée à un potential constant ($V_2$);
— des moyens d'évacuation sur une diode ($D_5$) des charges accumulées sur les diodes $D_1$ et $D_2$ pendant chaque intervalle de temps où aucune des grilles $G_0$ ne se trouve à zéro;
— au moins un registre à décalage ($R_1$) qui permet la mise à zéro périodique de chaque grille $G_0$ et l'évacuation des charges-signal sur les diodes $D_1$ puis sur les diodes $D_2$;
— des moyens assurant le transfert des charges-signal arrivant sous les diodes $D_2$ dans un registre de lecture à transfert de charges ($R_2$) à m entrées parallèle et à sortie série.

Selon un mode de réalisation préféré, le dispositif selon l'invention comporte une mémoire intégrée sur le substrat semiconducteur à la suite des diodes $D_2$ et sous laquelle les charges-signal sont recueillies avant d'être transférées dans le registre de lecture ($R_2$).

Parmi les principaux avantages du dispositif selon l'invention, on peut citer:

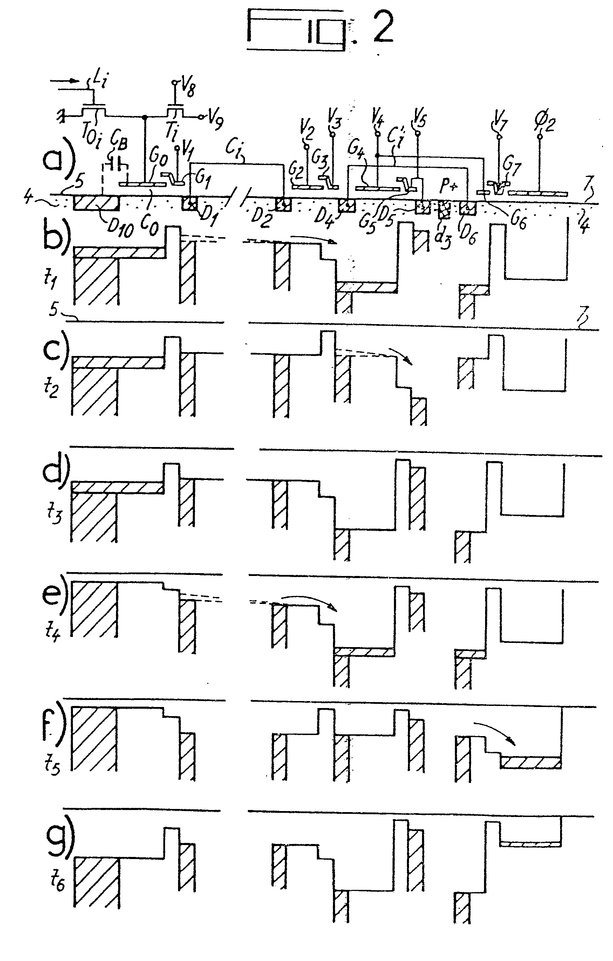

— le fait qu'en même temps que la lecture des charges-signal on réalise leur évacuation de la zone photosensible du dispositif par transfert de ces charges des diodes de lecture $D_1$ vers les diodes $D_2$ à travers les connexions métalliques $C_1 \ldots C_n$. Il n'est donc plus nécessaire comme dans le cas des dispositifs C.I.D. classiques ou dans le cas du dispositif C.I.D. de l'article I.E.E.E. cité d'effectuer une ré-injection des charges dans le substrat.
— de même, le fait que les diodes de lecture $D_1$ remplissent également une fonction communément appelée »anti-blooming« (anti-éblouissement). En effet lorsqu'un point photosensible se trouve trop intensément éclairé, la capacité $C_0$ de stockage des charges pour ce point déborde dans la diode $D_1$ adjacente. Entre deux lectures d'une ligne (étape $T_2$), on évacue (étape $T_1$) les charges qui ont débordé dans les diodes $D_1$. De plus, n diodes $D_1$ sont connectées en parallèle par chaque connexion $C_i$, les charges dues à un éclairement trop intense peuvent donc se répartir sur ces n diodes avant de déborder dans le substrat. Les diodes $D_1$ qui assurent à la fois l'évacuation des charges de la partie photosensible et la fonction anti-blooming permettent d'éviter l'utilisation de diffusions collectrices horizontales et d'électrodes verticales destinées à isoler les cellules les unes des autres comme cela est généralement le cas dans les dispositifs C.I.D. (voir les »guard stripes« et »field shield electrodes« sur les figures 2, 3 et 4 du document I.E.E.E. cité ainsi que la commentaire de ces figures);

— le fait que le dispositif selon l'invention comporte généralement une mémoire où les charges correspondant à la lecture d'une ligne de points photosensibles sont stockées temporairement avant d'être transférées dans le registre de lecture à transfert de charge. Dans le dispositif selon l'invention, comme dans celui décrit par l'article d'I.E.E.E., le transfert des charges de chaque ligne vers le registre de lecture est du type »Bucket Brigade«. L'adjonction d'une mémoire permet de disposer d'un temps égal à celui d'une lecture ligne (soit 52 µs pour le standard TV 625 lignes) pour effectuer l'évacuation des charges parasites sur les diodes $D_1$ et $D_2$ et le transfert d'une ligne en mémoire alors que dans le dispositif déçrit par l'article d'I.E.E.E., ces temps était réduit à celui du retour ligne (12 µs).

D'autres objets, caractéristiques et résultats de l'invention ressortiront de la description suivante donnée à titre d'exemple non limitatif et illustrée par les figures annexées qui représentent:

— la figure 1, une représentation schématique vue de dessus d'un mode de réalisation du dispositif selon l'invention;

— la figure 2a, une vue en coupe longitudinale du dispositif représenté sur la figure 1 et les figures 2b à 2g des schémas illustrant le fonctionnement de ce dispositif;

— la figure 3, une représentation schématique vue de dessus d'un autre mode de réalisation de la zone photosensible du dispositif selon l'invention;

— la figure 4, des signaux de commande susceptibles d'être appliqués au dispositif selon l'invention;

— la figure 5, une représentation schématique vue de dessus d'un mode de réalisation d'un dispositif d'injection d'une quantité de charges supplémentaire $Q_0$ dans le dispositif photosensible selon l'invention;

— la figure 6a, une vue en coupe du dispositif représenté sur la figure 5, et les figures 6b à 6e, des schémas illustrant le fonctionnement de ce dispositif;

— la figure 7, une représentation schématique vue de dessus d'un autre mode de réalisation de la mémoire, du dispositif d'évacuation des charges parasites et du registre de lecture du dispositif photosensible selon l'invention;

— les figures 8a et 9a, deux vues en coupe transversale du mode de réalisation représenté sur la figure 7 et les figures 8b, 8c et 9b, 9c, des schémas illustrant le fonctionnement de ce mode de réalisation;

— les figures 10a à 10d, des signaux de commande susceptibles d'être appliqués au dispositif selon l'invention.

Sur les différentes figures, les mêmes repères désignent les mêmes éléments, mais, pour des raisons de clarté les cotes et proportions des divers éléments ne sont pas respectées.

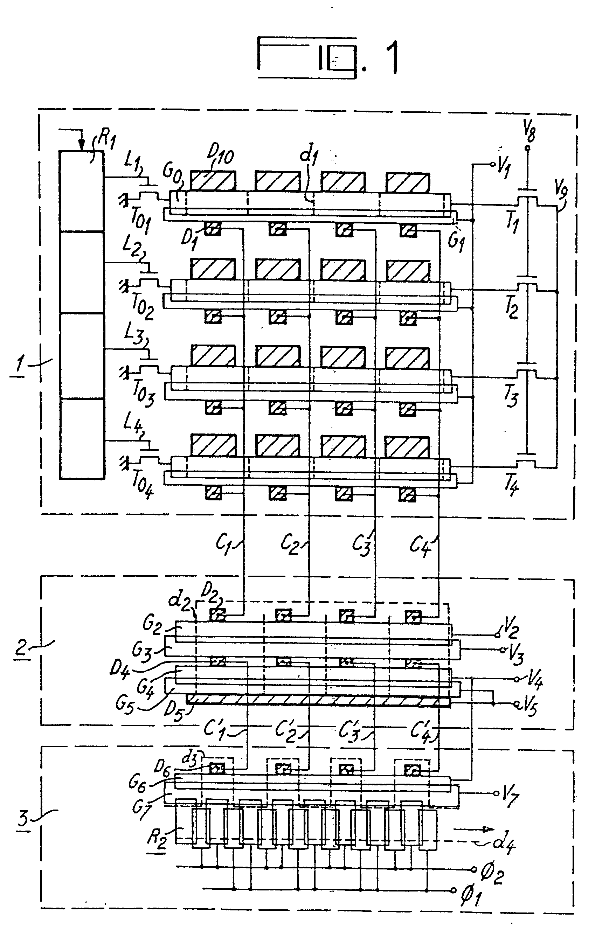

Sur la figure 1, on a représenté schématiquement vu de dessus un mode de réalisation du dispositif selon l'invention. Sur la figure 2a, on a représenté vu en coupe longitudinale le dispositif représenté sur la figure 1.

Le dispositif photosensible selon l'invention comporte essentiellement trois parties:

— une zone photosensible 1;
— une mémoire et un dispositif d'évacuation des charges parasites, cette partie étant repérée par 2;
— un registre de lecture 3.

On va décrire successivement chacune de ces parties et expliquer comment elles sont reliées entre elles.

La zone photosensible 1 comporte une matrice de points photosensibles. Sur la figure 1, cette matrice comprend quatre lignes et quatre colonnes, et donc 16 points photosensibles.

Chaque point photosensible est constitué par l'intégration sur un substrat semi-conducteur 4, qui est généralement du silicium:

— d'une capacité MOS $C_0$ constituée par une grille $G_0$, horizontale et commune aux points d'une même ligne. Sur chaque grille $G_0$, des diffusions d'isolement verticales $d_1$ déterminent la capacité $C_0$ de chaque point photosensible;
— d'une diode collectrice $D_{10}$ qui est sensible aux faibles longueurs d'onde auxquelles les grilles $G_0$ sont opaques. Les diodes $D_{10}$ sont diffusées localement à proximité des grilles $G_0$. Les diodes $D_{10}$ sont disposées en matrice. Sur la figure 1, chaque ligne de diodes $D_{10}$ est disposée en bordure de l'un des grand côtés d'une des grilles $G_0$ qui sont rectangulaires;
— d'une grille écran $G_1$ qui est portée à potentiel constant $V_1$. Sur la figure 1, la grille $G_1$ est horizontale et commune à tous les points photosensibles d'une même ligne. Comme la grille $G_0$, la grille $G_1$ est rectangulaire et borde l'autre grand côté de $G_0$ qui n'est pas occupé par les diodes $D_{10}$;
— d'une diode de lecture $D_1$. Les diodes de lecture $D_1$ sont disposées en matrice et quatre connexions métalliques verticales, $C_1$ à $C_4$, qui sont généralement en aluminium, relient en parallèle les quatre diodes de lecture $D_1$ d'une même colonne.

Les diodes collectrices $D_{10}$ doivent être fortement couplées aux grilles $G_0$ par des capacités de bord $C_B$ importantes par rapport aux capacités, $C_{D10}$, des diodes $D_{10}$ envers le substrat semi-conducteur 4. On doit avoir: $C_B \geqslant C_{D10}$. Pour cela, on augmente au maximum le périmètre commun entre chaque diode $D_{10}$ et la grille $G_0$ voisine. Ainsi le potentiel des diodes $D_{10}$ suit exactement le potentiel de surface sous la grille $G_0$ voisine.

Les diodes $D_{10}$ peuvent aussi être placées entre les grilles $G_0$ et $G_1$.

On peut aussi étendre la zone diffusée correspondant à chaque diode $D_{10}$ sous la grille $G_0$. Ceci a pour effet d'augmenter le couplage entre les diodes collectrices $D_{10}$ et les grilles $G_0$: ainsi est facilitée l'évacuation des charges stockées par chaque point photosensible; de plus, on accroît la quantité de charges qui peut être stockée par chaque point photosensible pour une même variation de potentiel sur la grille $G_0$.

Les grilles $G_0$ recoivent deux sortes de polarisation:

— d'une part, toutes les grilles $G_0$ de la zone photosensible sont soumises à un potantial constant $V_9$ qui permet l'intégration des charges en chaque point photosensible en fonction de l'éclairement reçu par ce point. Chaque grille $G_0$ est reliée à l'une des électrodes d'un transistor MOS $T_1$ à $T_4$ dont l'autre électrode est reliée à la tension continue $V_9$ et dont la grille reçoit un potentiel $V_8$ qui permet de rétablir le potentiel $V_9$ sur toute les grilles $G_0$. Le potentiel $V_8$ peut être une tension continue ou variable en fonction du temps. Dans le cas où $V_8$ est tension continue, le rétablissement du potentiel $V_9$ sur la grille $G_0$ qui était précédemment à zéro se fait avec une constante de temps relativement longue et la valeur de la capacité de stockage des charges $C_0$ augmente avec le temps. On réduit ainsi la quantité de charges collectées par génération thermique. Dans le cas où le potentiel $V_8$ est un signal variable en fonction du temps, c'est généralement le passage de $V_8$ au niveau haut qui provoque la mise en conduction des transistors $T_1$ à $T_4$ et le rétablissement instantané du potentiel $V_9$ sur toutes les grilles $G_0$;
— d'autre part, chaque grille $G_0$ reçoit périodiquement un potentiel nul qui provoque le transfert des charges signal stockés sous cette grille sous les diodes $D_1$, alors que les autres grilles $G_0$ sont maintenues au potentiel $V_9$ et que l'intégration des charges se poursuit sous ces grilles. Pour amener périodiquement à zéro l'une des grilles $G_0$, chaque grille $G_0$ est reliée à l'une des électrodes d'un transistor MOS $T_{01}$ à $T_{04}$ dont l'autre électrode est reliée à la masse et dont la grille reçoit des signaux de commande $L_1$ à $L_4$ issus de quatre étages successifs d'un registre à décalage $R_1$. Le passage d'un signal de commande $L_i$ au niveau haut provoque la mise à zéro d'une des grilles $G_0$.

On va maintenant examiner la mémoire et le dispositif d'évacuation des charges parasites 2 qui sont généralement intégrés sur le même substrat semi-conducteur 4 que celui sur lequel est intégrée la zone photosensible 1. La liaison entre les parties 1 et 2 du dispositif photosensible selon l'invention est assurée par quatre diodes $D_2$ qui sont intégrées sur le substrat semi-conducteur 4 et auxquelles aboutissent les connexions métalliques $C_1$ à $C_4$. Les diodes $D_2$ sont suivies par une grille $G_2$, horizontale et commune a toutes les diodes qui est portée à un potentiel constant $V_2$. La grille $G_2$ fixe à $V_2 - V_T$ le potentiel sur les diodes $D_2$ et sur les diodes de lecture $D_1$ connectées aux diodes $D_2$, $V_T$ représentant la tension de seuil sous la grille $G_2$.

La grille $G_2$ qui est reliée au potentiel constant $V_2$, comme les grilles $G_1$ reliées au potentiel constant $V_1$ permettent d'éviter l'envoi de parasites sur les connexions $C_1$ à $C_4$, ce qui aurait pour effet d'introduire dans la mémoire des charges parasites superposées aux charges-signal. Dans les dispositifs à transfert de charges, il est particulièrement important de se protéger contre les charges parasites dont l'amplitude peut varier d'un point à l'autre du circuit selon les variations géométrique des éléments et qui limitent la dynamique du signal.

De plus, les grilles $G_1$ isolent la zone photosensible 1 des parasites povenant des connexions $C_i$ et de la partie 2 du dispositif et, de même, la grille $G_2$ isole la partie 2 des parasites provenant des connexions $C_i$ et de la partie 1.

La grille $G_2$ est suivie par une grille $G_3$, qui comme $G_2$ est horizontale et unique. La grille $G_3$ est commandée par un signal $V_3$ périodique. La passage de $V_3$ d'un niveau haut à un niveau bas permet d'éviter le retour en arrière des charges transférées des diodes $D_1$ et $D_2$ vers la mémoire.

La mémoire est constituée par quatre diodes $D_4$ qui sont alignées et qui sont suivies par une grille unique horizontale $G_4$ qui est portée à un potentiel variable $V_4$. Dans cette mémoire sont successivement stockés deux types de charges:

— d'une part, les charges parasites accumulées sous les diodes $D_1$ et $D_2$ pendant chaque intervalle de temps où aucune des grilles $G_0$ ne se trouve à zéro;

— d'autre part, les charges-signal provenant de la mise à zéro d'une grille $G_0$.

La mémoire est suivie par un dispositif d'évacuation des charges parasites qui est constituées d'une grille $G_5$ unique et horizontale suivie d'une diode unique $D_5$, la grille $G_5$ et la diode $D_5$ étant connectées à un potentiel variable $V_5$.

Sur le substrat semi-conducteur 4, des diffusions d'isolement $d_2$ délimitent de façon connue la zone du substrat qui est réservée au traitement des charges issus de chaque colonne de points photosensibles et isolent les diodes $D_2$ des diodes $D_1$.

On va maintenant décrire la troisième partie du dispositif photosensible selon l'invention, c'est-à-dire le registre de lecture 3.

Le registre de lecture 3 est généralement intégré sur le même substrat semi-conducteur 4 que la mémoire et le dispositif d'évacuation des charges parasites 2, mais il s'en trouve isolé par une zone de diffusion d'isolement $d_3$ en créneaux.

A l'intérieur des créneaux, on trouve quatre diodes $D_6$ qui sont alignées et qui sont reliée par des connexions métalliques $C'_1$ à $C'_4$ aux quatre diodes $D_4$ de la mémoire. Ainsi s'effectue le transfert des charges-signal de la mémoire vers le registre de lecture. Les diodes $D_6$ sont suivies par une grille $G_6$, qui est horizontale et unique et qui est reliée au même potentiel variable $V_4$ que la grille $G_4$ de la mémoire.

La grille $G_6$ est suivie par une grille $G_7$, qui est également horizontale et unique et qui est reliée à un potentiel variable $V_7$ et qui permet lors de son passage au niveau haut le transfert de charges-signal vers le registre de lecture proprement dit $R_2$.

Sur la figure 1, le registre de lecture $R_2$ est un registre à C.C.D. à deux phases $\Phi_1$ et $\Phi_2$. Ce registre comporte une succession d'électrodes de stockage et d'électrodes de transfert de charge qui sont disposées sur une surépaisseur d'isolant par rapport aux électrodes de stockage. Une électrode de stockage sur deux aboutit à l'extrémité inférieure de la zone de diffusion d'isolement en créneau $d_3$ et ne reçoit donc pas de charges. Le transfert des charges dans le registre $R_2$ s'effectue horizontalement comme cela est indiqué par une flèche sur la figure 1. La lecture des charges-signal d'une ligne d'élément photosensible s'effectue donc en série.

Une diffusion d'isolement $d_4$ détermine la limite inférieure du canal de transfert des charges dans le registre $R_2$.

C'est à cause de la présence du dispositif d'évacuation des charges parasites que la liaison entre la mémoire et le registre de lecture 3 doit se faire par des connexions extérieures au substrat $C'_1$ à $C'_4$. De même que dans le cas diodes $D_{10}$ et de la grille $G_0$, il est nécessaire qu'un bon couplage existe entre les diodes $D_4$ et la grille $G_4$ ainsi qu'entre les diodes $D_6$ et la grille $G_6$.

On peut alors recouvrir par une couche isolante, puis par une couche d'aluminium chaque diode et une partie de la grille voisine. On prend alors un contact électrique à travers l'isolant au niveau de chaque grille.

La description précédente s'est placée dans le cas d'une matrice comportant quatre lignes et quatre colonnes photosensibles, il est bien évident que cette description s'applique au cas où la matrice comporte n lignes de m points photosensibles, où n et m sont des nombres entiers positifs.

On va maintenant expliquer le fonctionnement du dispositif selon l'invention représenté sur les figures 1 et 2a en décrivant les figures 2b à 2g. Les figures 2b à 2g représentent l'évolution du potentiel de surface $\Phi_S$ dans le substrat semi-conducteur 4 à divers instant $t_1$ à $t_6$. Les zones hachurées indiquent la présence de porteurs minoritaires. Sur les figures 2b à 2g, on n'a représenté que l'interface 5 et 7 du substrat 4 et de la couche isolante qui les recouvre.

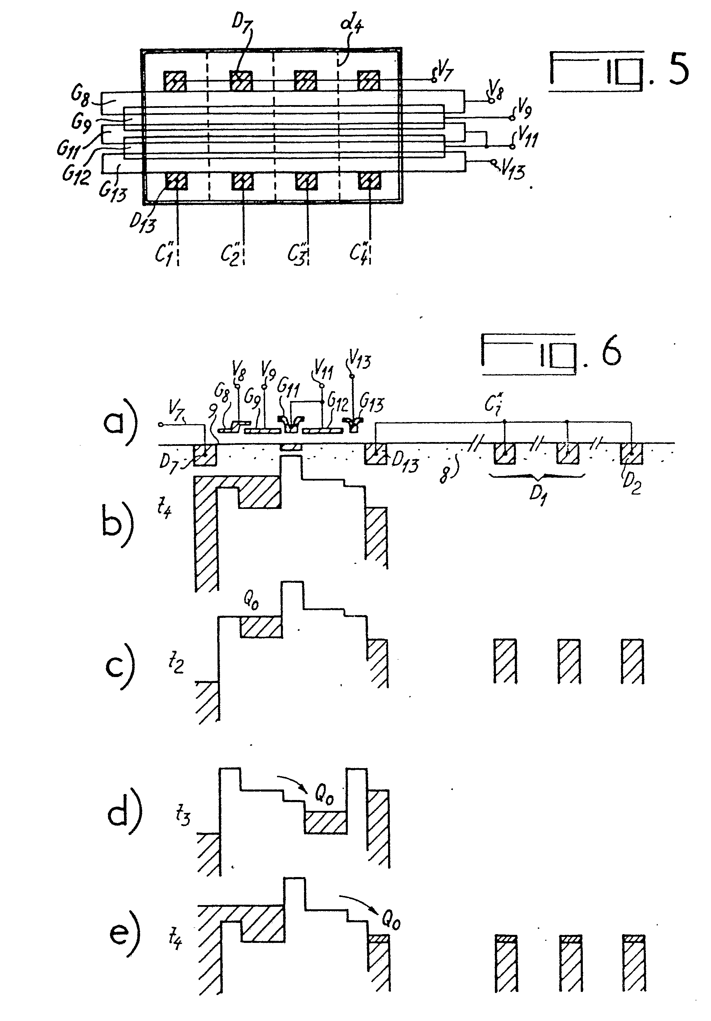

Les instants $t_1$ à $t_6$ sont repérés sur les figures 4a à 4f qui représentent les signaux de commande susceptibles d'être appliqués au dispositif selon l'invention. Ces signaux de commande sont des signaux périodiques dont l'amplitude varie entre un niveau bas et un niveau haut.

Sur les figures 4a et 4b, on a représenté les signaux $V_4$ et $V_3$ de même période $\frac{T}{2}$. Le signal $V_3$ revient au niveau bas un instant $\tau$ très bref avant $V_4$.

Sur les figures 4c et 4d, on a représenté les signaux $V_5$ et $V_7$ de même période T. Les signaux $V_5$ et $V_7$ sont en opposition de phase avec $V_3$. Sur les figures 4e et 4f, on a représenté les signaux $L_i$ et $L_{i+1}$. Ces signaux ont la même période nT. Ils passent au niveau haut un instant $\tau$ très court après le passage de $V_3$ niveau haut et reviennent au niveau bas en même temps que $V_3$.

Le fonctionnement du dispositif selon l'invention comporte la répétition de deux étapes distinctes de durées $T_1$ et $T_2$ que nous désignerons par la suite par »étape $T_1$« et »étape $T_2$«, la somme de $T_1$ et $T_2$ étant égale à T.

Au cours de l'étape $T_1$, toutes les grilles $G_0$ sont portées au potentiel $V_9$. On évacue alors les charges parasites qui se trouvent sur toutes les diodes $D_1$ et $D_2$ du dispositif vers la mémoire et ensuite vers le dispositif d'évacuation des charges parasites.

Pendant l'étape $T_2$, une seule des grilles $G_0$ de la zone photosensible se trouve au potentiel 0, alors que les autres grilles $G_0$ se trouvent au potentiel $V_9$. Les charges-signal stockées sous la grille au potentiel 0 sont transférées sur les diodes $D_1$ et $D_2$, puis sous la mémoire avant d'être transférées dans le registre de lecture $R_2$ où elles seront lues pendant l'étape $T_1$ suivante.

On va maintenant étudier en détail chacune des étapes $T_1$ et $T_2$.

Etape $T_1$:

— au temps $r_1$, seuls les signaux $V_3$ et $V_4$ sont au niveau haut. Toutes les grilles $G_0$ sont au potentiel $V_9$ et l'intégration des charges se poursuit dans chaque capacité $C_0$ et sur chaque diode $D_{10}$. Les charges parasites captées par les diodes $D_1$ et $D_2$ de tout le dispositif sont évacuées dans la mémoire comme le permet la grille $G_3$ qui est au niveau haut. Ces charges parasites proviennent essentiellement d'un débordement des capacités $C_0$ dû à un éclairement trop intense: c'est la fonction anti-blooming des diodes $D_1$. Les charges parasites peuvent être également des charges collectées latéralement par les diodes $D_1$ et $D_2$;

— au temps $t_2$-$\tau$, le signal $V_3$ revient à zéro et la grille $G_3$ isole alors la mémoire de la zone photosensible. Au temps $t_2$-$\tau$ également, le signal $V_5$ passe au niveau haut, la grille $G_5$ et la diode $D_5$ sont prêtes à recevoir les charges

parasites;

— au temps $t_2$, le signal $V_4$ revient à zéro et les charges parasites qui s'étaient réparties de façon égale sous les diodes $D_4$, les grilles $G_4$, les diodes $D_6$ et les grilles $G_6$ sont évacuées sous la diode d'évacuation $D_5$;

— au temps $t_3$, à nouveau, comme au temps $t_1$, seuls les signaux $V_3$ et $V_4$ sont au niveau haut, c'est la fin de l'étape $T_1$.

Etape $T_2$:

— au temps $t_4$, les signaux $V_3$, $V_4$ et $L_i$ sont au niveau haut. La grille $G_0$ de la zone photosensible qui est connectée au transistor MOS $T_{0i}$ commandé par le signal $L_i$ est alors reliée à zéro. Il y a alors transfert des charges-signal stockées par tous les points photosensibles se trouvant sous cette grille $G_0$ sur les diodes $D_1$ et $D_2$ puis dans la mémoire. Comme dans le cas de l'évacuation des charges parasites, le transfert des charges en mémoire se fait à un potentiel constant $V_2$—$V_T$ grâce à la grille $G_2$. On a vu précédemment que le transfert des charges en mémoire que ce soient les charges parasites ou les charges-signal est du type Bucket-Brigade c'est-à-dire qu'il se fait par l'intermédiaire de l'analogue d'un transistor MOS polarisé en saturation dont la source serait constituée par les diodes $D_1$ et $D_2$, dont la grille serait constituée par la grille $G_2$ portée au potentiel constant $V_2$ et dont le drain serait constitué par la diode $D_4$ portée par la grille $G_4$ à un potentiel $V_4$ supérieur à $V_3$. On a vu que pour être efficace ce type de transfert demande un temps relativement long. Dans le dispositif selon l'invention, l'existence de la mémoire permet de disposer d'un temps égal à celui d'une lecture ligne pour effectuer l'évacuation des charges parasites sur toutes les diodes $D_1$ et $D_2$ et le transfert d'une ligne $L_i$ en mémoire; en effet, pendant ce temps-là, le registre $R_2$ assure la lecture d'une ligne précédente $L_{i-1}$ de la matrice;

— au temps $t_5$-$\tau$, le transfert des charges-signal en mémoire étant terminé les signaux $V_3$ et $L_i$ passent au niveau bas alors que le signal $V_7$ passe au niveau haut. La grille $G_3$ isole à nouveau les connexions $C_i$ de la mémoire. La grille $G_7$ est portée au niveau haut et ouvre le passage vers le registre de lecture $R_2$;

— au temps $t_5$, le signal $V_4$ passe au niveau bas et il y a alors transfert des charges-signal qui s'étaient réparties sous les diodes $D_4$, $D_6$ et les grilles $G_4$ et $G_6$ dans registre de lecture $R_2$. Le transfert des charges-signal dans le registre de lecture doit s'effectuer pendant le temps de retour ligne, par contre toutes les étapes précédentes de $t_1$ à $t_5$-$\tau$ se produisent pendant le temps de lecture ligne. Après le temps $t_5$, le signal $V_8$ rétablit le potentiel $V_9$ sur la grille $G_0$ dont le contenu

vient d'être transféré dans le registre de lecture; dans le cas où le signal $V_9$ est un signal périodique, il peut être identique au signal $V_7$;

— au temps $t_6$, les signaux de commande reprennent leur valeur du temps $t_1$. Une nouvelle étape $T_1$ commence tandis que la ligne $L_i$ est lue par le registre $R_2$, cette lecture se prolonge pendant l'étape $T_2$ où le contenu de la ligne suivante $L_{i+1}$ est transféré en mémoire et se termine au prochain temps $t_5$-$\tau$.

Le dispositif photosensible selon l'invention peut recevoir le rayonnement lumineux à détecter soit par sa face avant où se trouvent les grilles $G_0$ et $G_1$, soit par sa face arrière. Dans le cas où le rayonnement lumineux est envoyé sur la face avant du dispositif, les grilles $G_0$ doivent être photosensibles; elles sont alors constituées de silicium polycristallin ou de métal semi-transparent. Les diodes de lecture $D_1$ sont alors entièrement recouvertes d'une couche isolante, puis d'aluminium afin d'éviter un éclairement parasite. De même, la mémoire, le dispositif d'évacuation des charges parasites et le registre de lecture sont recouverts d'une couche opaque qui les protège du rayonnement lumineux, et qui peut être une métallisation. Dans le cas où le rayonnement lumineux est envoyé sur la face arrière du dispositif photosensible, le substrat semi-conducteur 4 qui porte la zone photosensible 1 a alors une épaisseur réduite. Les connexions métalliques $C_1$ à $C_4$ permettent de disposer la mémoire, le dispositif d'évacuation des charges parasites et le registre de lecture à une certaine distance de la zone photosensible et sur une partie du substrat 4 dont l'épaisseur n'a pas été réduite. On évite ainsi un éclairement parasite de ces éléments.

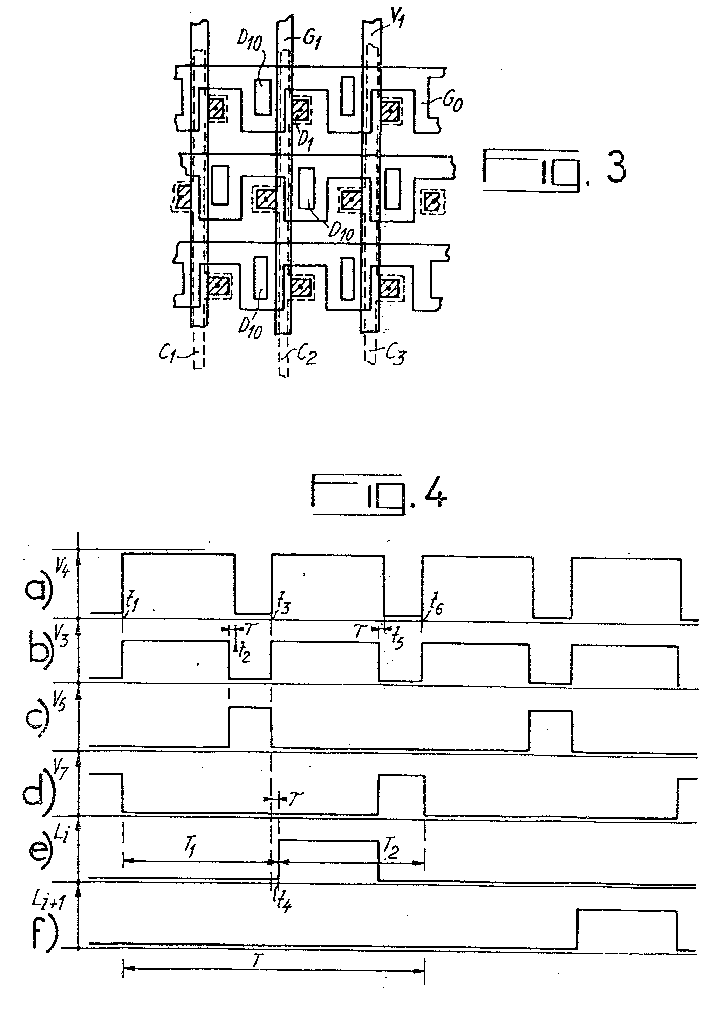

La figure 3 concerne une représentation schématique vue de dessus d'un autre mode de réalisation de la zone photosensible 1 du dispositif selon l'invention.

Dans ce mode de réalisation, les points photosensibles sont organisés en quinconce d'une ligne à l'autre.

Les grilles $G_0$ qui sont constituées par un premier niveau de silicium polycristallin sont disposées horizontalement. Ces grilles ont une forme rectangulaire et présentent des échancrures, rectangulaires également. Dans chaque échancrure se trouve une diode de lecture $D_1$. Les diodes de lectures $D_1$ sont disposées en quinconce car les échancrures sont décalées d'un demi-pas d'une grille $G_0$ à la suivante.

Sur chaque grille $G_0$ on trouve entre deux échancrures une ouverture qui constitue une zone collectrice $D_{10}$. Dans le cas de la figure 3 où les zones collectrices $D_{10}$ sont constituées par une simple zone d'oxyde mince sans diffusion et non plus par des diodes comme dans le cas de la figure 1, les porteurs crées par les photons sous ces zones collectrices rejoignent les capacités $C_0$, créées par les grilles $G_0$, par simple diffusion

plutôt que par conduction. Dans le cas de la figure 3, chaque grille $G_0$ reçoit les porteurs générés sur chaque zone collectrice $D_{10}$ par tout le pourtour de cette zone collectrice. Le remplacement des diodes par une simple couche d'oxyde mince pour constituer les zones collectrices est intéressant dans le cas où la condition: $C_B \gg C_{D10}$ ne peut être réalisée.

Dans ce mode de réalisation, les grilles $G_1$ sont constituées par un deuxième niveau de silicium polycristallin. Ces grilles sont verticales. Chaque grille $G_1$ recouvre en partie d'une part l'un des bords verticaux d'une échancrure réalisée sur chaque grille $G_0$ et d'autre part la diode de lecture $D_1$ se trouvant dans cette échancrure. Les diodes de lecture $D_1$ sont situées alternativement, d'une ligne à l'autre à droite et à gauche de l'électrode verticale $G_1$.

Sur les grilles $G_1$, on trouve, isolées par une couche d'oxyde épais, les connexions d'aluminium $C_i$. Sur la figure 3, les connexions $C_1$, $C_2$, $C_3$ sont représentées en traits discontinus. Ces connexions adressent les diodes de lecture $D_1$ par des prises de contacts à travers la couche d'oxyde.

Les avantages de la disposition des points photosensibles en quinconce, et non plus en matrice, sont les suivant:

— la résolution horizontale des points photosensibles est augmentée;

— les connexions $C_i$ sont totalement protégées de tout parasite par les grilles $G_1$ portées au potentiel constant $V_1$;

— de plus, l'intervalle entre les grilles réalisées sur le même niveau de silicium polycristallin n'est pas critique. En effet, le court-circuit de deux grilles $G_0$ n'affecte que deux lignes de la zone photosensible. Pour la première ligne, le signal lu est la somme des signaux des deux lignes. La deuxième ligne est lue comme une ligne noire car elle a été vidée par la lecture précédente. Enfin un court-circuit sur les grilles $G_1$ est sans effet sur le fonctionnement du dispositif.

Le pas du registre à décalage $R_1$ qui est utilisé pour la mise à zéro périodique de chaque grille $G_0$ est en général plus grand que le pas des grilles $G_0$. On peut utiliser deux registres $R_1$ et $R'_1$ dont le pas est double de celui des grilles $G_0$. Les registres sont alors placés de part et d'autre de la zone photosensible. L'un des registres adressen les grilles $G_0$ de rang pair et l'autre adresse les grilles $G_0$ de rang impair. L'entrelaçage est facilité par cette organisation qui peut s'utiliser en même temps que la disposition en quinconce. Ainsi l'un des registres peut adresser les grilles $G_0$ de rang impair et les points photosensibles placés à droite des connexions $C_i$, puis l'autre registre adresse les grilles $G_0$ de rangs pairs et les points photosensibles placés à gauche des connexions $C_i$.

On a vu dans la description du fonctionnement du dispositif représenté sur la figure 1 que ce fonctionnement comportait la répétition de deux étapes $T_1$ et $T_2$. La fonction anti-blooming n'est réalisée que pendant les étapes $T_1$. Les charges en surplus dues à des points photosensibles trop intensément éclairés et qui débordent sur leur diode de lecture $D_1$ sont prises en compte pendant les étapes $T_2$. Les charges en surplus dues à un point photosensible trop intensément éclairé se trouvent réparties sur toutes les diodes $D_1$ qui sont reliées à la diode de lecture $D_1$ de ce point trop intensément éclairé par une même connexion métallique $C_i$. Le niveau moyen du signal sur cette connexion $C_i$ se trouve ainsi élevé. Si ce point est éclairé avec une intensité B fois supérieure à celle qui produit la quantité de charges, Q, maximum au niveau d'un point photosensible, le niveau moyen pour les diodes reliées à la connexion $C_i$ est élevé de la quantité:

$$\frac{B}{N} \cdot \frac{T_1}{T} \cdot Q,$$

où N représente le nombre de grille $G_0$ de la zone photosensibel 1.

Ainsi une zone photosensible qui comporte 500 grilles $G_0$ et pour laquelle on a $T_1 = T_2$, peut tolérer un suréclairement B de l'ordre de 1000.

On a avantage pour amélior la résistance du dispositif au suréclairement à augmenter la durée de l'étape $T_2$ par rapport à celle de l'étape $T_1$.

Le temps $T_2$ est limité par le temps nécessaire pour que s'effectue le transfert des charges-signal $Q_S$ le long de chaque connexion $C_i$ jusqu'à la mémoire. On a vu que ce transfert s'effectue à travers l'équivalent d'un transistor MOS en saturation.

Si on appelle $c_i$ la capacité de la connexion $C_i$, la charge résiduelle $Q_r$ sous les diodes de lecture $D_1$ reliées par $C_i$ s'exprime:

$$Q_r = \frac{Q_S}{1 + B \dfrac{Q_S}{2} \cdot T}, \text{ avec } B = \frac{W}{L} \cdot \mu \cdot C_{Ox}$$

où $C_{Ox}$ est la capacité de la grille $G_2$ par unité de surface, W la largeur de cette grille, L sa longueur et $\mu$ la mobilité des porteurs minoritaires du substrat.

On constate donc que pour diminuer la charge résiduelle on a avantage à diminuer la capacité $c_i$.

Il apparaît aussi que les charges-signal $Q_S$ de faibles valeurs sont moins bien transmises que les charges de valeurs plus élevées. La sensibilité du dispositif est donc moindre pour les bas niveaux lumineux.

On peut améliorer de façon notable le transfert des faibles quantités de charges-signal $Q_S$ en leur superposant une charge fixe $Q_0$ obtenue en augmentant de $\Delta V$ le potentiel de la grille $G_2$ au temps $t_4$. Dans ce cas la charge transférée s'écrit:

$Q_S + Q_0$ avec $Q_0 = c_i \cdot \Delta V$.

En sortie du registre de lecture $R_2$, on obtient alors un signal superposé à un fond de charge $Q_0$ qui facilite par ailleurs le transfert des charges dans le registre.

L'inconvénient de ce procédé peut être dans certains cas d'ajouter au signal un bruit dû aux variations de la capacité $c_i$ d'une connexion $C_i$ à l'autre qui introduisent des variations sur la quantité $Q_0$ introduite d'une colonne à l'autre.

Les figures 5 et 6a, concernent une représentation schématique vue de dessus et vue en coupe longitudinale d'un mode de réalisation d'un dispositif d'injection d'une quantité de charges supplémentaire $Q_0$ dans le dispositif photosensible selon l'invention.

Avec ce dispositif les quantités de charges injectées $Q_0$ sont identiques pour tous les points de la zone photosensible et indépendantes des valeurs des capacités $c_i$ des connexions $C_i$.

Ce dispositif est constitué par l'intégration sur un substrat semi-conducteur (qui peut être le même que celui sur lequel est intégré le reste du dispositif photosensible) d'un nombre de diodes $D_7$ égal au nombre de connexions $C_i$. Sur la figure 5, quatre diodes $D_7$ sont représentées. Ces diodes sont portées à un potentiel variable $V_7$. Deux grilles coplanaires $G_8$ et $G_9$ suivent ces diodes. Ces grilles sont portées à deux potentiels constants $V_8$ et $V_9$, avec $V_8$ inférieur à $V_9$. Ainsi le passage des diodes $D_7$ d'un niveau bas à un niveau haut permet de stocker sous $G_9$ une quantité de charges $Q_0$ telle que:

$(Q_0 = (V_9 - V_8) \cdot C_{G9}$, où $C_{G9}$ représente la capacité de stockage sous la grille $G_9$.

Ainsi la quantité de charges $Q_0$ stockée sous $G_9$ est indépendante des variations de tension seuils sous $G_8$ et $G_9$ d'un point photosensible à l'autre et ne dépend que de la géométrie de $G_9$ dont la variation d'un bout à l'autre du dispositif peut être réduite au second ordre.

Des diffusions d'isolement verticales $d_4$ délimitent de façon connue la zone du substrat qui est réservée au traitement des charges issues d'une seule diode $D_7$.

Les figures 6b à 6e représentent des schémas illustrant le fonctionnement du dispositif représenté sur les figures 5 et 6a aux instants $t_4$, $t_2$ $t_3$ et nouveau $t_4$.

Sur ces figures, on n'a représenté que l'interface 9 du substrat 8 et de la couche isolante qui le recouvre.

Sur les figures 6b et 6c, on a représenté le stockage de la quantité de charges $Q_0$ sous la grille $G_9$.

La grille $G_9$ est suivie par une grille $G_{11}$ et une électrode de stockage $G_{12}$ qui sont portées à un potentiel variable $V_{11}$.

Au temps $t_3$, chaque quantité de charges $Q_0$ est transférée de $G_9$ sous $G_{12}$.

La grille $G_{12}$ est suivie par une grille écran $G_{13}$

portée à un potentiel constant $V_{13}$. Après la grille $G_{13}$, on trouve quatre diodes $D_{13}$ qui sont connectées par des connexions métalliques $C''1$ à $C''4$ aux diode $D_1$ et $D_2$, c'est-à-dire aux connexions $C_1$ à $C_4$.

Au temps $t_4$, le potentiel $V_{11}$ passe à zéro et provoque le transfert de chaque quantité de charges $Q_0$ sous les diodes $D_{13}$, $D_1$ et $D_2$ connectées en parallèles. La charge $Q_0$ est donc introduite au même instant $t_4$ que la charge signal $Q_S$ de la ligne lue. La génération de $Q_0$ se fait à la lecture de chaque ligne d'éléments photosensibles.

La géométrie de la mémoire et du registre de lecture doit être prévue pour que puisse être stockée la charge totale égale à : $Q_0 + Q$, où $Q$ est la charge-signal maximum au niveau d'un point photosensible.

A la place du dispositif représenté sur la figure 5, on peut utiliser un registre à décalages CCD, à sorties en parallèle. Chacune des sorties en parallèle de ce registre est reliée, par des connexions métalliques à l'un des couples de diodes $D_1 - D_2$, c'est-à-dire à l'une des connexions $C_1$ à $C_4$. Pendant le temps de lecture d'une ligne — de $t_1$ à $t_5 - \tau$ — ce registre est adressé par les mêmes signaux de commande que le registre de lecture $R_2$. On injecte à l'entrée en permanence une charge $Q_0$, de sorte qu'au début du temps de retour ligne, $t_5 - \tau$, on dispose de la charge $Q_0$ dans chacun des étages du registre. Cette charge est la même pour tous les étages puisqu'elle a été générée par un étage d'entrée unique et que l'inefficacité de transfert a un effet négligeable sur un signal continu. Seule la charge recombinée dans le substrat introduit une dispersion mais sa valeur est en général très faible.

Lorsqu'il y a transfert des charges-signal $Q_S$ de la ligne lue des diodes $D_1$ vers les diodes $D_2$ par les connexions $C_1$ à $C_4$, on vide en même temps latéralement le registre CCD. La charge $Q_0$ se trouve ainsi superposée au signal sur toutes les colonnes. C'est la somme des charges $Q_0 + Q_S$ qui est transférée dans le registre de lecture.

Le transfert des charges dans le registre à décalages CCD, à sorties en parallèle qui est utilisé peut se faire en surface ou en volume. Le transfert en surface permet de véhiculer une charge $Q_0$ plus importante à surface égale.

Comme celui qui est représenté sur la figure 5, ce dispositif d'injection permet d'injecter des quantités de charges $Q_0$ identiques pour tous les points de la zone photosensible et indépendantes des valeurs des capacités $c_i$ des connexions $C_i$. Le registre à décalages CCD à sorties en parallèle est généralement intégré sur le même substrat semi-conducteur que le reste du dispositif photosensible.

On va maintenant décrire un autre mode de réalisation de la mémoire, du dispositif d'évacuation des charges parasites et du registre de lecture du dispositif photosensible selon l'invention, c'est-à-dire des parties de ce dispositif qui sont repérées par 2 et 3 sur la figure 1.

On a voulu dans ce mode de réalisation effectuer le transfert des charges-signal de la mémoire vers le registre de lecture $R_2$ sans utiliser des diodes comme les diodes $D_4$ et $D_6$ qui sont réunis deux à deux par des connexions métalliques externes au substrat $C'_1$ à $C'_4$.

Ce mode de réalisation présente ainsi l'avantage par rapport à celui représenté sur la figure 1 d'éliminer les parasites susceptibles d'être introduits par un couplage variable, d'un point photosensible à l'autre entre d'une chaque diode $D_4$ ou $D_6$ et la grille $G_4$ ou $G_6$ adjacente et d'autre part entre chaque couple de diodes $D_4$ et $D_6$ (connexion $C'_i$).

On a voulu également dans ce mode de réalisation obtenir une meilleure homogénéité sur la largeur $l$ de la grille $G_2$ portée au potentiel constant $V_2$ qui suit les diodes $D_2$; on a voulu également pouvoir rendre cette largeur $l$ beaucoup plus petite.

Ainsi, ce mode de réalisation présente l'avantage d'éliminer les parasites susceptibles d'être introduits par une pénétration variable d'un point photosensible à l'autre des diodes $D_2$ sous la grille $G_2$; cette pénétration variable peut conduire à des temps de transfert variables des charges-signal de chaque diode $D_2$ vers la mémoire en raison de la largeur variable de la grille du transistor MOS équivalent à travers lequel se fait le transfert des charges en mémoire; de plus, ce mode de réalisation présente l'avantage d'augmenter la rapidité du transfert des charges-signal de $D_1$ et $D_2$ en mémoire, à cause de la diminution de la largeur de $G_2$.

Enfin, ce mode de réalisation présente l'avantage de simplifier les signaux de commande.

En contre partie de ces avantages, ce mode de réalisation impose des contraintes de fabrication un peu plus sévères en ce qui concerne les dimensions des différents éléments.

La figure 7, concerne une représentation schématique vue de dessus de ce mode de réalisation.

Les figures 8a et 9a représentent des vues en coupe transversale du mode de réalisation représenté sur la figure 7.

Après les diodes $D_2$ reliées par les connexions $C_1$ à $C_4$ aux diodes de lecture $D_1$, on trouve la grille $G_2$ portée au potentiel constant $V_2$.

La grille $G_2$ est entourée de deux grilles coplanaires $G_{14}$ et $G_4$ qui sont maintenues à un potentiel constant $V'_4$ supérieur à $V_2$. Ainsi la largeur $l$ de la grille $G_2$ est déterminée en une seule opération de photogravure par l'intervalle entre les grilles $G_{14}$ et $G_4$. Ainsi on obtient une meilleure homogénéité sur la largeur $l$ qui peut, par ailleurs, être rendue beaucoup plus petite.

La grille $G_4$ comme les grilles $G_0$ de la figure 3, est une grille rectangulaire présentant des échancrures rectangulaires également.

La figure 8a est une vue en coupe transversale du mode de réalisation représenté sur la figure 7 dans une zone de faible largeur de $G_4$,

c'est-à-dire au niveau d'une échancrure.

La figure 9a est une vue en coupe transversale du mode de réalisation représenté sur la figure 7 dans l'intervalle entre deux échancrures.

Dans chaque partie de substrat placée sous une échancrure de $G_4$, se trouve une diode d'évacuation $D_5$.

Une zone de diffusion d'isolement en »U« $d_5$ entoure chaque diode $D_5$.

Cette zone de diffusion d'isolement détermine deux canaux sur chaque partie du substrat 4 réservée par la zone de diffusion $d_2$ au traitement des charges en provenance d'une des connexions $C_1$ à $C_m$:

— le canal 1, (figure 9a), qui conduit au registre de lecture $R_2$; cet accès étant réglé par une grille $G_7$, portée à un potentiel variable $V'_7$ et qui est à cheval entre l'extrêmité de $G_4$ et le début de $R_2$;

— le canal 2, (figure 8a), qui conduit vers la diode d'évacuation $D_5$. Chaque diode $D_5$ est alors commune à deux points mémoires adjacents pour de raisons de gain de place. Il est donc possible de supprimer une diode $D_5$ sur deux. Cela présente l'avantage soit de permettre un pas horizontal plus réduit, soit d'augmenter la capacité de stockage de la mémoire de ligne.

Dans ce cas, une sur deux des parties verticales de la zone de diffusion $d_2$, c'est-à-dire les parties verticales qui ne sont pas suivies par une diode $D_5$, sont alors prolongées et aboutissent à une électrode de stockage qui ne reçoit donc pas de charges.

L'accès vers la diode $D_5$ est alors réglé par une électrode rectangulaire $G_{15}$ portée à un potentiel variable $V_{15}$. Cette électrode se trouve à cheval sur la partie horizontale des échancrures de $G_4$. Elle se trouve séparée de $G_4$ par une couche d'oxyde non représentée. Le potentiel $V_{15}$ est également appliqueé aux diodes $D_5$.

Les figures 8a et 9a représente des vues en coupe transversale selon les canaux 2 et 1.

On va maintenant examiner le fonctionnement de ce mode de réalisation en se referant aux figures 8b, 8c et 9b, 9c qui représentent l'évolution du potentiel de surface dans le substrat semi-conducteur 4a à différents instants $t'_1$, $t'_2$, $t'_3$.

Ces instants sont repérés sur les figures 10a à 10d qui représentent les signaux de commande susceptibles d'être appliqués à ce mode de réalisation.

Sur les figures 10c et 10d, on retrouve les signaux $L_i$ et $L_{i+1}$ déjà représentés sur les figures 4e et 4f.

Sur les figures 10a et 10b, on a représenté les signaux $V_{15}$ et $V_{17}$.

Ces signaux sont périodiques de période T et varient entre un niveau bas et un niveau haut.

Le signal $V_{15}$ se trouve au niveau haut lorsque les signaux $L_i$, $L_{i+1}$ . . . et le signal $V'_7$ sont au niveau bas.

Les signaux $L_i$, $L_{i+1}$ . . . passent au niveau haut un instant après que $V_{15}$ soit passé au niveau bas. Le signal $V'_7$ passe au niveau haut un instant $\tau$ après le passage de $L_i$, $L_{i+1}$ . . . au niveau bas. Enfin, le signal $V'_7$ revient au niveau bas un instant $\tau$ avant le passage de $V_{15}$ au niveau haut.

L'étape $T_1$ se déroule à partir du moment où $V_{15}$ est au niveau haut jusqu'au moment où $L_i$, $L_{i+1}$ . . . passent au niveau haut.

L'étape $T_2$ se déroule pendant le reste de la période T.

On va examiner les étapes $T_1$ et $T_2$.

Etape $T_1$:

— au temps $t'_1$, seul le signal $V_{15}$ se trouve au niveau haut.

La figure 8b représente les potentiels de surface à ce moment-là.

Les charges parasites de tous les points photosensibles sont évacuées des diodes $D_1$ vers les diodes $D_2$, puis sous la grille $G_4$ et enfin sous une diode d'évacuation $D_5$. Le transfert se fait au potentiel constant $V_2 - V_T$ grâce à la grille $G_2$;

Etape $T_2$:

— au temps $t'_2$, seul le signal $L_i$ se trouve au niveau haut. Les figures 8c et 9b représentent les potentiels de surface dans le substrat à ce moment-là. Les charges-signal de la ligne $L_i$ sont alors transférées des diodes $D_1$ vers les diodes $D_2$ puis stockées sous la grille $G_4$ qui sert de mémoire.

— au temps $t'_3$, seul le signal $V'_7$ se trouve au niveau haut.

La figure 9c représente le potentiel de surface dans le substrat à ce moment-là. Il y a alors transfert des charges-signal de la ligne $L_i$ qui sont stockées sous $G_4$ sous le registre de lecture $R_2$.

Une nouvelle étape $T_1$ commence ensuite tandis que la ligne $L_i$ est lue par le registre $R_2$.

Si le registre de lecture $R_2$ est un registre où le transfert des charges s'effectue en volume, il existe sous les électrodes du registre une zone diffusée z qui peut s'arrêter au milieu de la grille $G_7$.

Dans ce cas, le potentiel sous le registre $R_2$ est plus élevé que sous $G_4$ ce qui facilite le transfert des charges.

La superposition d'une charge fixe $Q_o$ aux charges-signal $Q_S$ peut se faire des deux façons indiquées précédemment, c'est-à-dire:

— en augmentant de $\Delta V$ le potentiel de $G_2$ au temps $t'_2$;

— ou, en utilisant le dispositif des figures 5 et 6a à 6e. Dans ce cas, l'étape représentée sur la figure 6e se fait au temps $t'_2$.

Il est bien entendu que la présente invention concerne généralement un dispositif photosensible intégré sur un substrat semiconducteur en silicium. Il est également possible de rapporter sur un substrat en silicium des détecteurs photosensibles en un matériau différent.

Le dispositif selon l'invention peut aussi fonctionner en donnant des résultats aussi satisfaisants que ceux obtenus par le dispositif décrit par l'article I.E.E.E. en transférant les charges-signal au fur et à mesure qu'elles arrivent dans le registre de lecture $R_2$ sans les stocker en mémoire.

Enfin le dispositif selon l'invention est préférentiellement un dispositif CCD, où le transfert des charges se fait en surface ou en volume.

## Revendications

1. Dispositif photosensible lu par transfert de charges et comportant n lignes de m points photosensibles constitués par l'intégration sur un substrat semi-conducteur (4) de capacités MOS ($C_0$) et chaque ligne comportant une grille $G_0$ commune à ses divers points ledit dispositif comportant au moins un registre à décalage ($R_1$) qui permet la mise à zéro périodique de chaque grille ($G_0$) et étant caractérisé en ce que chaque point photosensible comprend une seule capacité MOS et une diode de lecture $D_1$, séparée de la grille $G_0$ par une grille écran $G_1$ portée à un potentiel constant $V_1$, m connexions métalliques ($C_1$ ... $C_m$) reliant en parallèle n diodes appartenant à n lignes différentes, ainsi qu'en ce qu'il comprend:

— m diodes $D_2$, intégrées sur le même substrat semi-conducteur, auxquelles aboutissent les m connexions métalliques, ces diodes étant suivies par une grille $G_2$ portée à un potentiel constant ($V_2$);
— des moyens d'évacuation sur une diode ($D_5$) des charges parasites accumulées sur les diodes $D_1$ et $D_2$ pendant chaque intervalle de temps où aucune des grilles $G_0$ ne se trouve à zéro, la mise à zéro périodique de chaque grille $G_0$ permettant l'évacuation des charges-signal sur les diodes $D_1$ puis sur les diodes $D_2$;
— des moyens assurant le transfert des charges-signal arrivant sur les diodes $D_2$ dans un registre de lecture à transfert de charges ($R_2$) à m entrées parallèle et à sortie série.

2. Dispositif selon la revendication 1, caractérisé en ce qu'il comporte une mémoire intégrée sur le substrat semi-conducteur à la suite des diodes $D_2$ et sous laquelle les charges-signal sont recueillies avant d'être transférées dans le registre de lecture ($R_2$).

3. Dispositif selon la revendication 2, caractérisé en ce que cette mémoire est constituée par m diodes ($D_4$) suivies par une grille ($G_4$) commune aux m diodes et portée à un potentiel variable ($V_4$).

4. Dispositif selon la revendication 3, caractérisé ce qu'il comporte, intégré sur le substrat à la suite de la mémoire, une grille $G_5$ et une diode $D_5$ reliées à un potentiel variable ($V_5$), cette diode recevant les charges parasites accumulées sous les diodes $D_1$ et $D_2$ pendant l'intervalle de temps où aucune des grilles photosensibles $G_0$ ne se trouve à zéro.

5. Dispositif selon la revendication 4, caractérisé en ce qu'il comporte, intégrés sur le substrat semi-conducteur (4):

— m diodes $D_6$ suivies par une grille unique $G_6$, chacune de ces diodes étant reliée par une connexion métallique ($C'_1$ ... $C'_m$) à la diode ($D_4$) correspondante de la mémoire et la grille $G_6$ étant portée au même potentiel variable ($V_4$) que la grille ($G_4$) de la mémoire;
— une grille unique $G_7$ portée à un potentiel variable ($V_7$);
— le registre de lecture à transfert de charges ($R_2$) dont la grille précédente $G_7$ permet le chargement, après que les charges-signal résultant de la lecture d'une ligne aient été recueillies par la mémoire.

6. Dispositif selon la revendication 5, caractérisé en ce qu'une couche d'oxyde et une couche d'aluminium recouvrent les diodes ($D_4$) de la mémoire et les diodes $D_6$ ainsi qu'une partie des grilles ($G_4$ et $G_6$) voisines, un contact électrique étant établi à travers l'isolant au niveau de chaque grille.

7. Dispositif selon l'une des revendications 2 à 6, caractérisé en ce qu'une grille ($G_3$) portée à un potentiel variable ($V_3$) est intercalée sur le substrat semi-conducteur entre la grille $G_2$ portée à un potentiel constant ($V_2$) et la mémoire.

8. Dispositif selon la revendication 2, caractérisé en ce que la grille $G_2$ est entourée de deux grilles coplanaires portées à un potentiel constant inférieur à $V_2$, l'une de ces grilles ($G_{14}$) étant adjacente aux diodes $D_2$ et l'autre grille $G_4$ constituant la mémoire.

9. Dispositif selon la revendication 8, caractérisé en ce que:

— la grille $G_4$ est une grille rectangulaire comportant des échancrures rectangulaires;
— au moins une sur deux de chaque partie du substrat (4) placée sous une échancrure comporte une diode d'évacuation des charges ($D_5$);
— une zone de diffusion d'isolement en »U« $d_5$ entoure chaque diode d'évacuation des charges ($D_5$) et détermine deux canaux sur la partie du substrat réservé au traitement des charges en provenance d'une des connexions métalliques ($C_1$ ... $C_m$);
— l'un des canaux (canal 2) qui conduit à une diode d'évacuation ($D_5$) permet l'évacuation sous la diode des charges parasites accumulées sous les diodes $D_1$ et $D_2$ pendant l'intervalle de temps où aucune des grilles photosensible $G_0$ ne se trouve à zéro, ce transfert étant commandé par une grille ($G_{15}$) placée à cheval sur la partie horizontal

des échancrures de $G_4$;
— l'autre canal (canal 1) permet le transfert des charges-signal d'une ligne stockées sous la grille $G_4$ dans le registre de lecture à transfert de charges ($R_2$), ce transfert étant commandé par une grille ($G_7$) à cheval sur l'extrêmité de $G_4$ et le début du registre.

10. Dispositif selon l'une des revendications 1 à 9, caractérisé en ce que chaque point photosensible comporte, à proximité de la grille $G_0$, une zone collectrice ($D_{10}$) sensible aux faibles longueurs d'onde auxquelles $G_0$ n'est pas sensible, les charges créées par le rayonnement sur ces zones ($D_{10}$) étant collectées sous les grilles $G_0$.

11. Dispositif selon la revendication 10, caractérisé en ce que chaque zone collectrice ($D_{10}$) est constituée par une diode ou par une simple zone d'oxyde mince.

12. Dispositif selon la revendication 10, caractérisé en ce que chaque zone collectrice ($D_{10}$) est constituée par une diode.

13. Dispositif selon la revendication 12, caractérisé en ce que la zone diffusée correspond à chaque diode, constituant une zone collectrice ($D_{10}$), s'étend sous la grille $G_0$ voisine.

14. Dispositif selon l'une des revendications 2 à 13, caractérisé en ce que le potentiel constant ($V_2$) appliqué à la grille $G_2$ suivant les diodes $D_2$ est augmenté d'une quantité constante $\Delta V$ lors du transfert des charges-signal sous la mémoire.

15. Dispositif selon l'une des revendications 2 à 13, caractérisé en ce qu'il comporte, intégré sur le même substrat semi-conducteur:

— m diodes ($D_7$) portées à un potentiel variable ($V_7$) suivies par;
— deux grilles coplanaires $G_8$ et $G_9$ portées à deux potentiels constants $V_8$ et $V_9$, avec $V_8$ inférieur à $V_9$, de façon qu'une quantité de charge constantes ($Q_0$) soit stockées sous $G_9$ lors du passage du potentiel appliqué à la diode du niveau bas au niveau haut:
— une grille ($G_{11}$) et une électrode de stockage ($G_{12}$) portées à un potentiel variable ($V_1$);
— une grille écran ($G_{13}$) portée à un potentiel constant ($V_{13}$);
— m diodes $D_{13}$ reliées par des connexions métalliques ($C''_1 \ldots C''_m$) aux m diodes $D_2$, la quantité de charges ($Q_0$) étant transférée sous chaque diode $D_{13}$ lors du transfert des charges-signal sous la mémoire.

16. Dispositif selon l'une des revendications 2 à 13, caractérisé en ce qu'il comporte, intégré sur le même substrat semi-conducteur, un registre à décalages CCD comportant m sorties en parallèle, chaque sortie étant reliées par une connexion métallique à l'un des couples de diodes $D_1—D_2$, ce registre recevant pendant le temps de lecture d'une ligne les mêmes signaux de commande que le registre de lecture ($R_2$) alors qu'une quantité de charge constante ($Q_0$) est injectée en permanence à l'entrée du registre et le contenu de ce registre étant vidé, lors du transfert des charges-signal ($Q_S$) de la ligne lue des diodes $D_1$ vers les diodes $D_2$.

17. Dispositif selon l'une des revendications 1 à 16, caractérisé en ce que la partie du substrat semi-conducteur (4) qui porte la zone photosensible (1) a une épaisseur réduite et reçoit l'éclairement par sa face arrière.

18. Dispositif selon l'une des revendications 1 à 16, caractérisé en ce que la partie du substrat semi-conducteur (4) qui porte la zone photosensible (1) reçoit l'éclairement par sa face avant et en ce que les grilles ($G_0$) sont photosensibles et les diodes de lecture ($D_1$) sont entièrement recouvertes d'aluminium.

19. Dispositif selon l'une des revendications 1 à 18, caractérisé en ce que les diodes de lecture ($D_1$) sont disposées en quinconce et se trouvent situées dans des échancrures rectangulaires réalisées sur les grilles horizontales $G_0$.

20. Dispositif selon la revendication 19, caractérisé en ce qu'il comporte m grilles verticales $G_1$ portées au potentiel $V_1$ qui recouvrent en partie d'une part, l'un des bords verticaux de chaque échancrure réalisée sur chaque grille $G_0$ et d'autre part, chaque diode de lecture $D_1$ située alternativement d'une ligne à l'autre à droite et à gauche de l'électrode verticale $G_1$.

21. Dispositif selon la revendication 20, caractérisé en ce que les m grilles verticales $G_1$, sont recouvertes d'une couche isolante sur laquelle sont déposées les m connexions métalliques ($C_1$ à $C_m$) qui relient en parallèle grâce à des prises de contact à travers la couche isolante n diodes de lecture $D_1$ appartenant à n grilles $G_0$ différentes.

22. Dispositif selon l'une des revendications 1 à 18, caractérisé en ce que les diodes de lecture $D_1$ et les diodes $D_2$ sont disposées en matrice.

23. Dispositif selon l'une des revendications 1 à 22, caractérisé en ce qu'il comporte deux registres à décalages qui adressent l'un les lignes de rang pair et l'autre les lignes de rang impair.

24. Dispositif selon l'une des revendications 1 à 23, caractérisé en ce que chaque grille $G_0$ est reliée à l'une des électrodes d'un transistor MOS ($T_{01} \ldots T_{0n}$) dont la grille est reliée à un registre à décalage ($R_1$) et dont l'autre électrode est reliée à la masse, le registre à décalage assurant la mise en conduction périodique de chaque transistor et la mise à zéro de chaque grille $G_0$.

25. Dispositif selon l'une des revendication 1 à 24, caractérisé en ce que chaque grille $G_0$ est reliée à l'une des électrodes d'un transistor MOS ($T_1 \ldots T_n$) dont l'autre électrode est reliée à un potentiel constant ($V_9$) et dont la grille reçoit un potentiel variable ($V_8$), qui provoque la mise en conduction des transistors et la mise au potentiel constant ($V_9$) des grilles $G_0$ après que le transfert des charges-signal d'une ligne dans le registre à transfert de charges ($R_2$) ait été effectué.

26. Dispositif selon l'une des revendications 1 à 24, caractérisé en ce que chaque grille $G_0$ est

reliée à l'une des électrodes d'un transistor MOS ($T_1 \ldots T_n$) dont l'autre électrode est reliée à un potentiel constant ($V_9$) et dont la grille reçoit un potentiel constant, ces transistors assurant le rétablissement, après une constante de temps, du potentiel constant ($V_9$) sous toutes les grilles $G_0$ après que le transfert des charges-signal d'une dans le registre à transfert de charges ($R_2$) ait été effectué.

27. Dispositif selon l'une des revendications 1 à 26, caractérisé en ce que le substrat semi-conducteur utilisé est du silicium.

28. Caméra de télévision, caractérisée en ce qu'elle comporte un dispositif selon l'une des revendications précédentes.

**Patentansprüche**

1. Lichtempfindliche Vorrichtung, die mittels Ladungstransfers gelesen wird und n Zeilen zu je m durch Integration von MOS-Kondensatoren ($C_0$) auf einem Halbleitersubstrat (4) gebildeten lichtempfindlichen Punkten besitzt, wobei jede Zeile ein ihren verschiedenen Punkten gemeinsames Gitter $G_0$ enthält und die Vorrichtung mindestens ein Schieberegister ($R_1$) besitzt, mit dem man periodisch jedes Gitter ($G_0$) auf Null setzen kann, dadurch gekennzeichnet, daß jeder lichtempfindliche Punkt einen einzigen MOS-Kondensator und eine Lesediode ($D_1$) enthält, die vom Gitter ($G_0$) durch ein Schirmgitter ($G_1$) getrennt ist, das auf ein konstantes Potential $V_1$ gebracht ist, wobei m metallische Verbindungen ($C_1 \ldots C_m$) parallel n zu verschiedenen Zeilen gehörende Dioden verbinden, und daß die Vorrichtung

— m auf demselben Halbleitersubstrat integrierte Dioden $D_2$, an denen die m metallischen Verbindungen enden und denen ein auf ein konstantes Potential ($V_2$) gebrachtes Gitter $G_2$ nachfolgt,
— Mittel zur Ableitung der auf den Dioden $D_1$ und $D_2$ angesammelten parasitären Ladungen auf eine Diode ($D_5$) während jedes Zeitraums, in dem keines der Gitter $G_0$ auf Null liegt, wobei die periodische Nullsetzung jedes Gitters $G_0$ die Übertragung der Signalladungen auf die Dioden $D_1$ und dann auf die Dioden $D_2$ ermöglicht,
— Mittel aufweist, mit denen die Signal-Ladungen, die in den Dioden $D_2$ ankommen, in ein Ladungstransfer-Leseregister ($R_2$) übertragen werden können, das m parallele Eingänge und einen Serienausgang besitzt.

2. Vorrichtung nach Anspruch 1, dadurch gekennzeichnet, daß sie einen auf dem Halbleitersubstrat integrierten Speicher im Anschluß an die Dioden $D_2$ aufweist, unter dem die Signal-Ladungen vor der Übertragung in das Leseregister ($R_2$) aufgenommen werden.

3. Vorrichtung nach Anspruch 2, dadurch gekennzeichnet, daß dieser Speicher aus m

Dioden ($D_4$) gefolgt von einem den m Dioden gemeinsamen Gitter ($G_4$) gebildet wird, das auf ein variables Potential ($V_4$) gebracht ist.

4. Vorrichtung nach Anspruch 3, dadurch gekennzeichnet, daß ein Gitter ($G_5$) und eine mit einem variablen Potential ($V_5$) verbundene Diode ($D_5$) auf dem Substrat in Anschluß an den Speicher integriert sind und daß diese Diode die unter den Dioden $D_1$ und $D_2$ angesammelten parasitären Ladungen während des Zeitraums empfängt, in dem keines der lichtempfindlichen Gitter $G_0$ sich auf Null befindet.

5. Vorrichtung nach Anspruch 4, dadurch gekennzeichnet, daß sich auf dem Halbleitersubstrat (4) integriert

— m Dioden $D_6$ gefolgt von einem einzigen Gitter $G_6$, wobei jede der Dioden über eine metallische Verbindung ($C'_1 \ldots C'_m$) an die entsprechende Diode ($D_4$) des Speichers angeschlossen ist und das Gitter $G_6$ auf dasselbe variable Potential ($V_4$) wie das Gitter ($G_4$) des Speichers gebracht ist,
— ein einziges Gitter $G_7$, das auf ein variables Potential ($V_7$) gebracht ist,
— ein Ladungstransfer-Leseregister ($R_2$) befindet, bei dem das obenerwähnte Gitter $G_7$ nach der Aufnahme der vom Lesen einer Zeile resultierende Signal-Ladungen das Laden erlaubt.

6. Vorrichtung nach Anspruch 5, dadurch gekennzeichnet, daß eine Oxidschicht und eine Aluminiumschicht die Dioden ($D_4$) des Speichers und die Dioden $D_6$ sowie einen Teil der benachbarten Gitter ($G_4$ und $G_6$) überdecken, wobei ein elektrischer Kontakt durch die Isolierung hindurch in Höhe jedes Gitters besteht.

7. Vorrichtung nach einem der Ansprüche 2 bis 6, dadurch gekennzeichnet, daß ein auf ein variables Potential ($V_3$) gebrachtes Gitter ($G_3$) auf dem Halbleitersubstrat zwischen das auf ein konstantes Potential ($V_2$) gebrachte Gitter $G_2$ und den Speicher eingefügt ist.

8. Vorrichtung nach Anspruch 2, dadurch gekennzeichnet, daß das Gitter $G_2$ von zwei auf ein niedrigeres Potential als $V_2$ gebrachten koplanaren Gittern umgeben ist, von denen das eine ($G_{14}$) neben den Dioden $D_2$ liegt und das andere $G_4$ den Speicher bildet.

9. Vorrichtung nach Anspruch 8, dadurch gekennzeichnet, daß

— das Gitter $G_4$ ein Rechteckgitter mit rechteckigen Ausschnitten ist,
— mindestens jeder zweite unter einem Ausschnitt liegende Teil des Substrats (4) eine Ladungs-Abfuhrdiode ($D_5$) aufweist,
— eine U-förmige Diffusions-Isolationszone ($d_5$) jede Ladungs-Abfuhrdiode ($D_5$) umgibt und zwei Kanäle auf dem für die Bearbeitung der von einer der metallischen Verbindungen ($C_1 \ldots C_m$) stammenden Ladungen reservierten Teil des Substrats bestimmt,

— einer der Kanäle (Kanal 2), der zu einer Ladungs-Abfuhrdiode ($D_5$) führt, die Abfuhr der unter den Dioden $D_1$ und $D_2$ angesammelten parasitären Ladungen während des Zeitraums erlaubt, in dem keines der lichtempfindlichen Gitter $G_0$ sich auf Null befindet, wobei diese Übertragung von einem rittlings auf dem horizontalen Bereich der Ausschnitte von $G_4$ sitzenden Gitter ($G_{15}$) gesteuert wird,

— der andere Kanal (Kanal 1) die Übertragung der unter dem Gitter $G_4$ gespeicherten Signal-Ladungen einer Zeile in ein Ladungstransfer-Leseregister ($R_2$) erlaubt, wobei diese Übertragung von einem Gitter ($G_7$) gesteuert wird, das rittlings auf dem Ende von $G_4$ und dem Anfang des Registers sitzt.

10. Vorrichtung nach einem der Ansprüche 1 bis 9, dadurch gekennzeichnet, daß jeder lichtempfindliche Punkt in der Nähe des Gitters $G_0$ eine Kollektorzone ($D_{10}$) besitzt, die auf geringe Wellenlängen, für die $G_0$ nicht empfindlich ist, anspricht, wobei die durch die Strahlung in diesen Zonen ($D_{10}$) erzeugten Ladungen unter den Gittern $G_0$ gesammelt werden.

11. Vorrichtung nach Anspruch 10, dadurch gekennzeichnet, daß jede Kollektorzone ($D_{10}$) aus einer Diode oder einer einfachen dünnen Oxidschicht besteht.

12. Vorrichtung nach Anspruch 10, dadurch gekennzeichnet, daß die Kollektorzone ($D_{10}$) aus einer Diode besteht.

13. Vorrichtung nach Anspruch 12, dadurch gekennzeichnet, daß die jeder Diode entsprechende diffundierte Zone, die eine Kollektorzone ($D_{10}$) bildet, sich unter das benachbarte Gitter $G_0$ erstreckt.

14. Vorrichtung nach einem der Ansprüche 2 bis 13, dadurch gekennzeichnet, daß das konstante Potential ($V_2$), das an das auf die Dioden $D_2$ folgende Gitter $G_2$ angelegt ist, um einen konstanten Betrag $\Delta V$ während der Übertragung der Signal-Ladungen unter den Speicher erhöht wird.

15. Vorrichtung nach einem der Ansprüche 2 bis 13, dadurch gekennzeichnet, daß sie auf demselben Halbleitersubstrat integriert

— m auf ein variables Potential ($V_7$) gebrachte Dioden ($D_7$) besitzt, gefolgt von:

— zwei koplanaren Gittern $G_8$ und $G_9$, die auf zwei konstante Potentiale $V_8$ und $V_9$ gebracht sind, wobei $V_8$ niedriger als $V_9$ ist, so daß eine Menge konstanter Ladungen ($Q_0$) unter $G_9$ gespeichert wird, wenn das an die Diode angelegte Potential vom niedrigen zum hohen Pegel übergeht;

— einem Gitter ($G_{11}$) und einer Speicherelektrode ($G_{12}$), die auf ein variables Potential ($V_{11}$) gebracht sind;

— einem Schirmgitter ($G_{13}$), das auf ein konstantes Potential ($V_{13}$) gebracht ist;

— m über metallische Verbindungen ($C''_1 \ldots C''_m$) an die m Dioden $D_2$ ange-

schlossenen Dioden $D_{13}$, wobei die Ladungsmenge ($Q_0$) unter jede Diode $D_{13}$ beim Übergang der Signal-Ladungen unter den Speicher übertragen werden.

16. Vorrichtung nach einem der Ansprüche 2 bis 13, dadurch gekennzeichnet, daß sie integriert auf demselben Halbleitersubstrat ein Schieberegister CCD mit m Parallelausgängen aufweist, wobei jeder Ausgang über eine metallische Verbindung an eines der Diodenpaare $D_1 - D_2$ angeschlossen ist und wobei das Register während der für eine Zeile benötigten Lesezeit die gleichen Steuersignale wie das Leseregister ($R_2$) zugeführt erhält, während eine konstante Ladungsmenge ($Q_0$) dauernd an dem Eingang des Registers eingespeist wird und der Inhalt des Registers während der Übertragung der Signalladungen ($Q_S$) der gelesenen Zeile von den Dioden $D_1$ an die Dioden $D_2$ entleert wird.

17. Vorrichtung nach einem der Ansprüche 1 bis 16, dadurch gekennzeichnet, daß der Teil des Halbleitersubstrats (4), der die lichtempfindliche Zone (1) trägt, eine verringerte Dicke besitzt und die Beleuchtung von seiner Rückseite zugeführt erhält.

18. Vorrichtung nach einem der Ansprüche 1 bis 16, dadurch gekennzeichnet, daß der Teil des Halbleitersubstrats (4), der die lichtempfindliche Zone trägt, die Beleuchtung von der Vorderseite zugeführt erhält und daß die Gitter ($G_0$) lichtempfindlich sind und die Lesedioden ($D_1$) vollständig mit Aluminium bedeckt sind.

19. Vorrichtung nach einem der Ansprüche 1 bis 18, dadurch gekennzeichnet, daß die Lesedioden ($D_1$) auf Lücke angeordnet sind und sich in den rechteckigen Ausschnitten befinden, die auf den waagerechten Gittern $G_0$ vorhanden sind.

20. Vorrichtung nach Anspruch 19, dadurch gekennzeichnet, daß sie m senkrechte Gitter $G_1$ aufweist, die auf das Potential $V_1$ gebracht sind und teilweise einerseits einen der senkrechten Ränder jedes auf jedem Gitter $G_0$ vorhandenen Ausschnitts und andererseits jede Lesediode $D_1$ überdecken, die abwechselnd von einer Zeile zur anderen rechts und links von der senkrechten Elektrode $G_1$ angebracht ist.

21. Vorrichtung nach Anspruch 20, dadurch gekennzeichnet, daß die m senkrechten Gitter $G_1$ von einer isolierenden Schicht überdeckt sind, auf der die m metallischen Verbindungen ($C_1$ bis $C_m$) liegen, welche über Kontaktstellen durch die isolierende Schicht hindurch n zu n verschiedenen Gittern $G_0$ gehörende Lesedioden $D_1$ parallel miteinander verbinden.

22. Vorrichtung nach einem der Ansprüche 1 bis 18, dadurch gekennzeichnet, daß die Lesedioden $D_1$ und die Dioden $D_2$ in Matrixanordnung vorliegen.

23. Vorrichtung nach einem der Ansprüche 1 bis 22, dadurch gekennzeichnet, daß sie zwei Schieberegister aufweist, von denen das eine die Zeilen mit geradem Rang und das andere die Zeilen mit ungeradem Rang adressiert.

24. Vorrichtung nach einem der Ansprüche 1 bis 23, dadurch gekennzeichnet, daß jedes Gitter $G_0$ an eine der Elektroden eines MOS-Transistors $(T_{01}, \ldots T_{0n})$ angeschlossen ist, dessen Gitter an ein Schieberegister $(R_1)$ und dessen andere Elektrode an Masse angeschlossen ist, wobei das Schieberegister periodisch jeden Transistor leitend steuert und jedes Gitter $G_0$ auf Null setzt.

25. Vorrichtung nach einem der Ansprüche 1 bis 24, dadurch gekennzeichnet, daß jedes Gitter $G_0$ mit einer der Elektroden eines MOS-Transistors $(T_1 \ldots T_n)$ verbunden ist, dessen andere Elektrode an ein konstantes Potential $(V_9)$ angeschlossen ist und dessen Gitter ein variables Potential $(V_8)$ empfängt, durch das die Transistoren leitend gesteuert werden und die Gitter $G_0$ an das konstante Potential $(V_9)$ gelangen, nach dem die Signal-Ladungen einer Zeile in das Ladungstransfer-Register $(R_2)$ übertragen worden sind.

26. Vorrichtung nach einem der Ansprüchen 1 bis 24, dadurch gekennzeichnet, daß jedes Gitter $G_0$ an eine der Elektroden eines MOS-Transistors $(T_1 \ldots T_n)$ angeschlossen ist, dessen andere Elektrode an einem konstanten Potential $(V_9)$ liegt und dessen Gitter ein konstantes Potential zugeführt erhält, wobei die Transistoren nach einer Zeitkonstante die Wiederherstellung des konstanten Potentials $(V_9)$ unter allen Gittern $G_0$ nach der Übertragung der Signal-Ladungen einer Zeile in das Ladungstransfer-Register $(R_2)$ bewirken.

27. Vorrichtung nach einem der Ansprüche 1 bis 26, dadurch gekennzeichnet, daß das verwendete Halbleitersubstrat aus Silizium ist.

28. Fernsehkamera, dadurch gekennzeichnet, daß sie eine Vorrichtung nach einem der vorherigen Ansprüche besitzt.

**Claims**

1. A light sensitive device which is read by charge transfer and which comprises n lines of m light sensitive points, constituted by the integration of MOS capacitors $(C_0)$ on a semiconductor substrate (4), each line being provided with a grid $G_0$ common to the different points of that line, the device comprising at least one shift register $(R_1)$, permitting a periodical zero setting of each grid $(G_0)$, and being characterized in that each light sensitive point includes only one MOS capacitor and one reading diode $D_1$ separated from the grid $G_0$ by a screen grid $G_1$ which is connected to a constant potential $V_1$, m metal connections $(C_1 \ldots C_m)$ connecting parallelly n diodes which belong to n different lines, and characterized in that the device comprises

— m diodes $D_2$, integrated on the same semiconductor substrate and connected to the metal connections, the diodes being followed by a grid $G_2$ which is connected to a constant potential $(V_2)$,
— means for evacuating to a diode $(D_5)$ parasite charges which have been accumulated on the diodes $D_1$ and $D_2$ during each time interval in which neither of the grids $G_0$ is set to zero, the evacuation of the signal charges to the diodes $D_1$ and then to the diodes $D_2$ being allowed by the periodical zero setting of each grid $G_0$,
— means for ensuring the transfer of the signal charges arriving at the diodes $D_2$ to a charge transfer reading register $(R_2)$ having m parallel input and a series output.

2. A device according to claim 1, characterized in that it comprises, integrated on the semiconductor substrate, a memory behind the diodes $D_2$, the signal charges being gathered under the memory before their transfer to the reading register $(R_2)$.

3. A device according to claim 2, characterized in that this memory consists of m diodes $(D_4)$ followed by a grid $(G_4)$ which is common to the m diodes and which is branched to a variable potential $(V_4)$.

4. A device according to claim 3, characterized in that, integrated to the substrate behind the memory, the device comprises a grid $G_5$ and a diode $D_5$ both connected to a variable potential $(V_5)$, this diode receiving the parasite charges which have been accumulated under the diodes $D_1$ and $D_2$ during the time interval in which neither of the light sensitive grids $G_0$ ist at zero level.

5. A device according to claim 4, characterized in that, integrated on the semiconductor substrate (4), the device comprises

— m diodes $D_6$ followed by a unique grid $G_6$, each diode being connected by a metal connection $(C'_1 \ldots C'_m)$ to the corresponding diode $(D_4)$ of the memory, and the grid $G_6$ being branched to the same variable potential $(V_4)$ as the grid $(G_4)$ of the memory;
— a unique grid $G_7$ branched to a variable potential $(V_7)$;
— the charge transfer reading register $(R_2)$ which is charged through the unique grid $G_7$ as soon as the signal charges resulting from the reading operation of one line have been gathered by the memory.

6. A device according to claim 5, characterized in that an oxide layer and an aluminium layer cover the diodes $(D_4)$ of the memory and the diodes $D_6$ as well as part of the adjacent grids $(G_4$ and $G_6)$, an electrical contact being established through the insulating material at the level of each grid.

7. A device according to one of the claims 2 to 6, characterized in that a grid $(G_3)$ branches to a variable potential $(V_3)$ is interposed on the semiconductor substrate between the grid $G_2$ which is branched to a constant potential $(V_2)$ and the memory.

8. A device according to claim 2, characterized in that the grid $G_2$ is surrounded by two coplanar grids which are branched to a constant potential lower than $V_2$, one of the grid $(G_{14})$ being adjacent to the diodes $D_2$ and the other grid $G_4$ constituting the memory.

9. A device according to claim 8, characterized in that

- the grid $G_4$ is a rectangular grid having rectangular cut-out parts;
- at least one out of two of each substrate (4) zone placed under a cut-out part comprises a diode for evacuating the charges $(D_5)$;
- a U-shaped insulating diffusion zone $(d_5)$ surrounds each diode for evacuating the charges $(D_5)$ and determines two channels on the zone of the substrate reserved to the processing of the charges coming from one of the metal connections $(C_1 \ldots C_m)$;
- one of the channels (channel 2) leading to an evacuation diode $(D_5)$ permits the evacuation under the diodes of parasite charges which have been accumulated under the diodes $D_1$ and $D_2$ during the time interval in which neither of the light sensitive grid $(G_0)$ is at zero level, this transfer being controlled by a grid $(G_{15})$ which is straddling on the horizontal zone of the cut-out parts of $G_4$;
- the other channel (channel 1) permits the transfer of these signal charges of a line stored under the grids $G_4$ into the charge transfer reading register $(R_2)$, this transfer being controlled by a grid $(G_7)$ which straddles the end portion of $G_4$ and the start portion of the register.

10. A device according to one of the claims 1 to 9, characterized in that each light sensitive points comprises close to the grid $G_0$ a collector zone $(D_{10})$ which is sensitive to small wavelengths to which $G_0$ is not sensitive, the charges created by the radiation in these zones $(G_{10})$ being collected under the grids $G_0$.

11. A device according to claim 10, characterized in that each collector zone $(D_{10})$ consists of a diode or of a simple thin oxide zone.

12. A device according to claim 10, characterized in that each collector zone $(D_{10})$ consists of a diode.

13. A device according to claim 12, characterized in that the diffused zone corresponding to each diode and constituting a collector zone $(D_{10})$ extends under the adjacent grid $G_0$.

14. A device according to one of the claims 2 to 13, characterized in that the constant potential $(V_2)$ applied to the grid $G_2$ following the diodes $D_2$ is increased by a constant quantity $\Delta V$ during the transfer of the signal charges under the memory.

15. A device according to one of the claims 2 to 13, characterized in that, integrated on the same semiconductor substrate, it comprises

- m diodes $(D_7)$ branched to a variable potential $(V_7)$ and followed by:
- two coplanar grids $G_8$ and $G_9$ branched to

two constant potentials $V_8$ and $V_9$, $V_8$ being lower than $V_9$, in such a way that a quantity of constant charges $(Q_0)$ is stored under $G_9$ during the transition of the potential applied to the diodes from the low level to the high level;
- a grid $(G_{11})$ and a storage electrode $(G_{12})$ branched to a variable potential $(V_{11})$;
- a screen grid $(G_{13})$ branched to a constant potential $(V_{13})$;
- m diodes $D_{13}$ connected by metal connections $(C''_1 \ldots C''_m)$ to the m diodes $D_2$, the quantity of charges $(Q_0)$ being transferred under each diode $D_{13}$ when the signal charges are transferred under the memory.

16. A device according to one of the claims 2 to 13, characterized in that, integrated on the same semiconductor substrate, it comprises a shift register CCD having m parallel outputs, each output being connected by a metal connection to one of the diode pairs $D_1-D_2$, this register receiving, during the time of reading one line, the same control signals as the reading register $(R_2)$, whereas a constant quantity of charges $(Q_0)$ is permanently injected to the input of the register, and this register being emptied during the transfer of the signal charges $(Q_S)$ of the line from the diodes $D_1$ to the diodes $D_2$.

17. A device according to one of the claims 1 to 16, characterized in that the part of the semiconductor substrate (4) bearing the light sensitive zone (1) has a reduced thickness and receives the radiation from its backside surface.

18. A device according to one of the claims 1 to 16, characterized in that the part of the semiconductor substrate (4) bearing the light sensitive zone (1) receives the radiation by its front surface and that the grids $(G_0)$ are light sensitive and the reading diodes $(D_1)$ are completely covered with aluminium.

19. A device according to one of the claims 1 to 18, characterized in that the reading diodes $(D_1)$ are staggered and are situated in the rectangular cut-out parts realized on the horizontal grids $G_0$.

20. A device according to claim 19, characterized in that it comprises m vertical grids $G_1$ branched to the potential $V_1$ which partially cover in the one hand one of the vertical sides of each cut-out part realized on each grid $G_0$ and on the other hand each reading diode $D_1$ which is alternately situated from one line to the next one to the right and to the left of the vertical electrode $G_1$.

21. A device according to claim 21, characterized in that the m vertical grids $G_1$ are covered with an insulating layer on which the m metal connections $(C_1$ to $C_m)$ are deposited and connect in parallel n reading diodes $D_1$ belonging to n different grids $G_0$ via contact points through the insulating layer.

22. A device according to one of the claims 1 to 18, characterized in that the reading diodes $D_1$ and the diodes $D_2$ are disposed in a matrix form.

23. A device according to one of the claims 1 to 22, characterized in that it comprises two shift registers, one of which adresses the lines of even rank and the other the lines of odd rank.

24. A device according to one of the claims 1 to 23, characterized in that each grid $G_0$ is connected to one of the electrodes of a MOS transistor ($T_{01} \ldots T_{0n}$), the grid of which is connected to a shift register ($R_1$) and the other electrode of which is connected to earth, the shift register ensuring the periodic conduction of each transistor and the zero setting of each grid $G_0$.

25. A device according to one of the claims 1 to 24, characterized in that each grid $G_0$ is connected to one of the electrodes of a MOS transistor ($T_1 \ldots T_n$), the other electrode of which is connected to a constant potential ($V_9$) and the grid of which receives a variable potential ($V_8$) which provokes the transistors to conduct and to branch the grids $G_0$ to the constant potential ($V_9$)

when the transfer of the signal charges from one line into the charge transfer register ($R_2$) has been accomplished.

26. A device according to one of the claims 1 to 24, characterized in that each grid $G_0$ is connected to one of the electrodes of a MOS transistor ($T_1 \ldots T_n$), the other electrode of which is connected to a constant potential ($V_9$) and the grid of which receives a constant potential, these transistors ensuring, after a time constant, the re-establishement of the constant potential ($V_9$) under all the grids, when the transfer of the signal charges from one line to the charge transfer register ($R_2$) has been accomplished.

27. A device according to one of the claims 1 to 26, characterized in that the employed semiconductor substrate is made of silicon.

28. A television camera, characterized in that it comprises a device according to one of the preceding claims.

Fig. 1

FIG. 2

0 038 725

Fig. 3

Fig. 4

23

FIG. 5

FIG. 6

0 038 725

$C_1$  $C_2$  $C_3$  $C_4$

$d_2$

$D_2$

$G_{14}$

$G_2$

$V_2$

$V'_4$

$G_4$

Canal 2   Canal 2

$V_{15}$

Canal 1   $D_5$

$G_{15}$

$V'_7$

$G_7$

$G_7$

$d_5$

$R_2$

$d_4$

$\phi_2$
$\phi_1$

$\underline{2+3}$

Fig. 7

0 038 725

FIG. 8

FIG. 9

FIG. 10

29